(19) Europäisches Patentamt
European Patent Office
Office européen des brevets

(11) **EP 2 005 466 B1**

(12) **EUROPEAN PATENT SPECIFICATION**

(45) Date of publication and mention of the grant of the patent:
**17.07.2013 Bulletin 2013/29**

(21) Application number: **07726870.4**

(22) Date of filing: **13.03.2007**

(51) Int Cl.:
***H01L 21/762*** *(2006.01)*

(86) International application number:
**PCT/EP2007/052372**

(87) International publication number:
**WO 2007/104767 (20.09.2007 Gazette 2007/38)**

(54) **METHOD FOR MAKING A STRUCTURE COMPRISING AT LEAST ONE THIN LAYER IN AN AMORPHOUS MATERIAL OBTAINED BY EPITAXY ON A SUPPORTING SUBSTRATE**

VERFAHREN ZUR HERSTELLUNG EINER STRUKTUR MIT MINDESTENS EINER DÜNNEN SCHICHT IN EINEM AMORPHEN MATERIAL, ERHALTEN DURCH EPITAXIE AUF EINEM TRÄGERSUBSTRAT

PROCEDE DE FABRICATION D'UNE STRUCTURE COMPRENANT AU MOINS UNE COUCHE MINCE DE MATERIAU AMORPHE OBTENUE PAR EPITAXIE SUR UN SUBSTRAT SUPPORT

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **13.03.2006 FR 0602178**

(43) Date of publication of application:
**24.12.2008 Bulletin 2008/52**

(73) Proprietor: **Soitec**
**38190 Bernin (FR)**

(72) Inventor: **HEBRAS, Xavier**
**F-38100 Grenoble (FR)**

(74) Representative: **Regimbeau**
**20, rue de Chazelles**
**75847 Paris Cedex 17 (FR)**

(56) References cited:
**US-A- 5 298 449      US-A1- 2004 262 686**
**US-A1- 2005 085 055      US-B1- 6 638 872**
**US-B1- 6 696 352**

- **NISHIKAWA S ET AL: "Elimination of secondary defects in preamorphized Si by C<+> implantation", INSPEC,, 18 January 1993 (1993-01-18), XP002622861,**

## Description

The present invention relates to a method for making a structure comprising at least one thin layer in an amorphous material obtained by so-called solid phase epitaxy (SPE), on a supporting substrate.

A non-limiting application of the invention relates to the making of a semiconductor substrate, the upper layer of which is doped for example for forming CMOS (Complementary Metal Oxide SemiConductor) components, such as transistors for example, as described in US 6638872.

In this respect, it is specified that in the field of micro-electronics, one may try to reduce the electrical resistance of the layers of a substrate intended for making electronic components. This reduction in resistance may notably be obtained by increasing the concentration of the carriers.

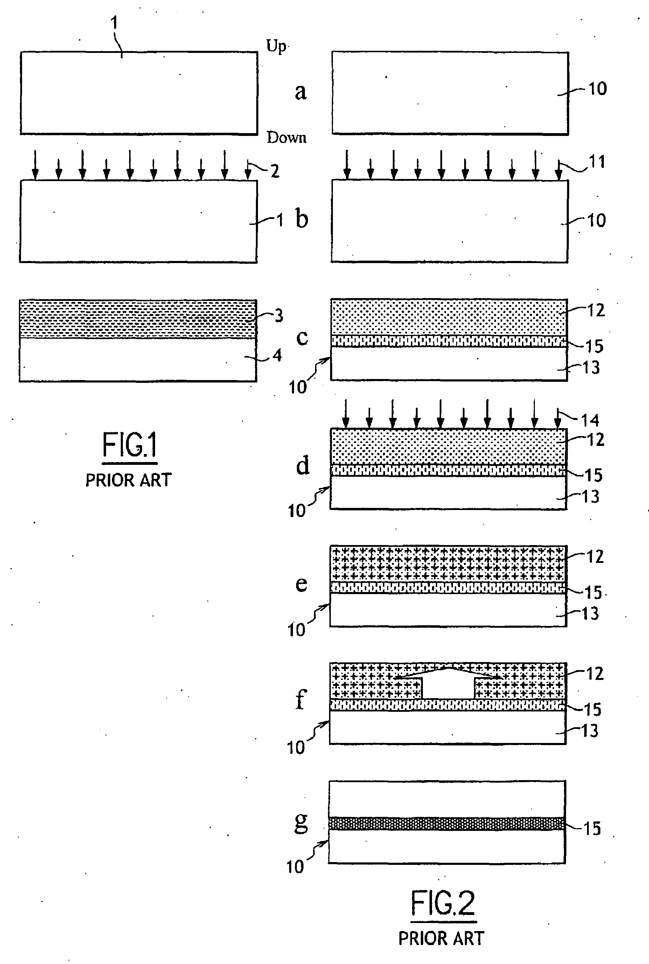

This increase in the concentration of carriers, the main steps of which are schematically illustrated in Fig. 1, is obtained in a conventional way by doping the substrate 1, illustrated in Fig. 1a and generally made in silicon, by implanting a dopant species 2, with reference to Fig. 1b. The implantation is typically performed with dopant species such as phosphorous or boron, for example. The substrate obtained according to such a known method, with reference to Fig. 1c, thus comprises an upper doped zone 3 and a lower crystalline zone 4.

However, the dopant species has limiting solubility which corresponds to the maximum concentration of the carriers, which may be produced in the supporting substrate.

It would thus be advantageous to be able to dope the substrate beyond standard solubility limits of the order of 1 e20 at/cm$^3$.

For this purpose, applying a so-called solid phase epitaxy (SPE) is also known, the main steps of which are schematically illustrated in Fig. 2.

The solid phase epitaxy is illustrated in Fig. 2 for treating a supporting substrate 10 which is typically in silicon.

During a first step (Fig.2b), atomic species 11 such as silicon are implanted from the upper face of the supporting substrate in order to create an upper amorphous layer 12 in the supporting substrate 10, as illustrated in Fig. 2c.

Thus, after implantation of atomic species, the substrate includes a lower crystalline layer 13 and an upper amorphous layer 12.

It will be noted that this implantation of species 11 also generates immediately underneath the amorphous layer 12, a region 15 which contains a few atomic species (such as silicon) in interstitial positions without however the structure of this region 15 being describable as « amorphous ».

In a second optional step, with reference to Figs. 2d and 2e, a doping species 14 such as phosphorous or boron is implanted in the amorphous layer 12.

Next, with reference to Fig. 2f, after the previous optional step for implanting a dopant species, low temperature recrystallization annealing is performed, the dopant species 14 implanted in the amorphous layer 12 being then activated so that the dopant species 14 is put in a substitutional position in the layer 12 in a large proportion.

By low temperature recrystallization annealing, is meant a heat treatment at a temperature between 550°C and 650°C which allows recrystallization of the amorphous layer 12 from the crystalline layer 13 of the substrate 10, this layer 13 playing a role of seed layer.

With such a technique, it is thereby possible to activate the dopants beyond their limiting solubility in the supporting substrate 10. It will be noted that, in the case of silicon, the limiting solubility of most current dopants varies between 1 e18 and 1.5e20 at/cm$^3$ for temperatures from 800°C to 1,150°C. With this increase in the solubility of the dopants, the concentration of carriers in the supporting substrate 10 may be increased, this causing a lowering of the source/drain resistances of the electronic components made on the substrate and, consequently, low power consumption of said components.

However, this technique is also associated with a drawback. Indeed, end of range (EOR) type defects are generated at the end of the recrystallization annealing, in the region 15 immediately located under the recrystallized layer 12.

These EOR defects are caused by crystalline defects which appear during the amorphization step and which develop during the recrystallization step.

These EOR defects considerably deteriorate electrical performances and more particularly the mobility of the carriers of the substrate 10 so that these substrates are unsuitable for making electronic components.

Thus, the SPE type methods, if they actually allow the limiting solubility of dopants to be increased in a substrate, are associated with certain limitations.

The object of the invention is to give the possibility of getting rid of these limitations.

For this purpose, and according to claim 1, a method is proposed for making a structure comprising at least one thin layer on a receiving substrate,

The structure obtained following the method according to the invention allows the substrate to be doped beyond the limiting solubility of the dopants. Further, the dopable substrate does not include any point defects.

The amorphous layer is formed either at the surface of the intermediate structure, or on the intermediate structure by depositing an epitaxied crystalline layer followed by total or partial amorphization of said layer or even further by depositing an amorphous layer, for example.

Alternatively, the amorphous layer may be made in the intermediate structure so that it forms the upper layer, the so-called surface amorphous layer of the intermediate structure.

According to another alternative, the amorphous layer is made in the intermediate structure so that it forms a buried layer, a so-called buried amorphous layer, immediately located underneath a third crystalline layer located in the upper portion of the intermediate structure..

Preferably, the amorphous layer is obtained by implanting species in said supporting substrate.

Prior to the step for bonding the receiving substrate, it includes a step for doping the amorphous layer by implanting species through the upper face of said intermediate structure.

After the steps for forming the amorphous layer and removing the layer of the intermediate structure in which point defects have formed, and prior to the step for bonding a receiving substrate, it includes a step for doping the amorphous layer by implanting species.

The dopants implanted in the amorphous layer are activated by applying a heat treatment which recrystallizes said amorphous layer.

Said heat treatment is performed between 550°C and 650°C for one to two hours.

The step for removing the layer of the intermediate structure in which point defects have formed is preferably obtained by creating a weakened zone in the intermediate structure and then by applying stresses.

The step for removing the layer of the intermediate structure in which point defects have formed during the formation of the amorphous layer is performed according to the steps of:

- implanting ions or gas species through the upper layer of the intermediate structure so as to form in the intermediate structure, a buried weakened zone,
- causing fracture in the weakened zone leading to detachment of the upper layer of the intermediate structure.

Other advantages and features of the invention will become better apparent from the description which follows of several alternative embodiments, given as non-limiting examples, of the method according to the invention, with reference to the appended drawings wherein, in addition to Figs. 1 and 2 on which comments have already been made with reference to the state of the art:

- Fig. 3 is a schematic illustration of the main steps of the method for making a substrate according to the invention,
- Fig. 4 is a schematic illustration of the main steps of a first alternative embodiment of the method for making a substrate according to the invention,
- Fig. 5 is a schematic illustration of the main steps of a second alternative embodiment of the method for making a substrate according to the invention,
- Fig. 6 is a schematic illustration of the main steps of a third alternative embodiment of the method for making a substrate according to the invention,
- Fig. 7 is a dose/depth diagram of SiGe systems for different implantation energies.
- Fig. 8 is a graph illustrating the concentration of implanted species versus the depth in the substrate.

We shall describe a preferred embodiment of the invention in which several alternative embodiments may be contemplated.

**Alternative embodiment with a buried amorphous layer and removal of point defects with weakening by implantation**

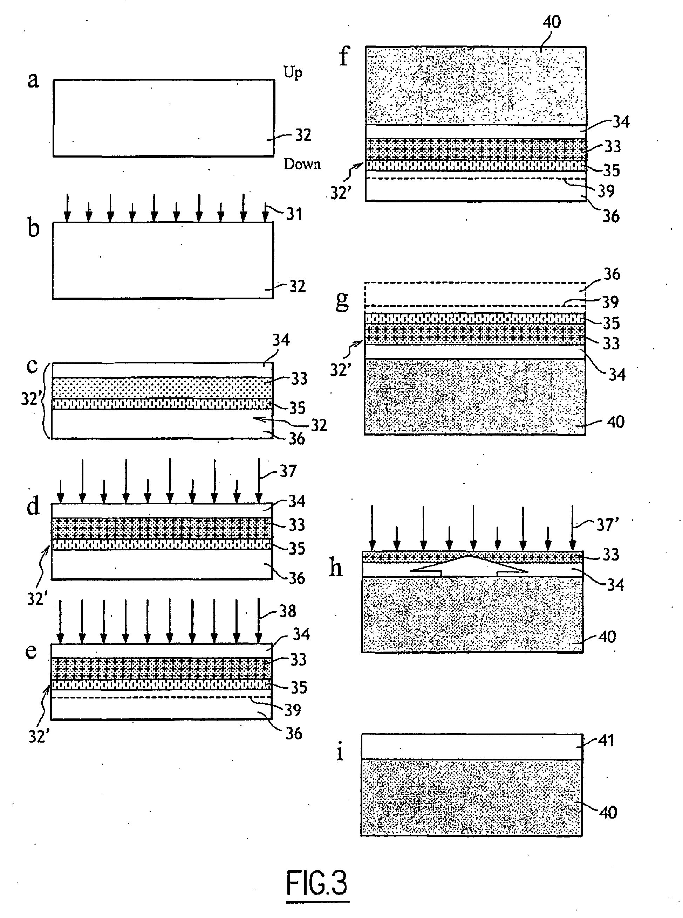

With reference to Fig. 3, according to a preferred embodiment of the invention, the method includes a step for implanting species 31 (Fig. 3b) from the upper face of a substrate 32 (Fig. 3a) so as to form a buried amorphous layer 33, with reference to Fig. 3c.

Substrate 32 for example has a general disc shape which extends in a horizontal direction. Further, in the following text, by upper face, i.e., the top of the substrate 32, is meant the face which receives the first implantation of species 31.

Substrate 32 is a semiconductor material such as silicon.

And species 31 may for example be Si.

In order to obtain a buried layer 33, the implantation parameters are controlled in order to retain at the surface of the substrate 32, a region 34, the crystallinity of which is not changed by the implanted species 31.

After forming the buried amorphous layer 33, the supporting substrate 31 has a so-called intermediate structure 32', with reference to Fig. 3c, consisting of an upper layer 34 which has remained crystalline, of a buried amorphous layer 33 located under the upper crystalline layer 34, of a central crystalline layer 35 containing crystalline point defects immediately located underneath the buried amorphous layer 34 and a lower crystalline layer 36. These point defects are interstitial Si atoms, they correspond to defects of the layer 15 of Fig. 2c-2e and they are the cause of point defects of the EOR type.

Optionally, with reference to Fig. 3d, dopant species 37 such as boron and/or phosphorus are locally implanted or in the full plate in the amorphous layer 33 through the upper face of the intermediate structure 32'.

Ions and/or gas species 38 are then implanted through the upper face of the substrate so as to form in the substrate, a buried weakened zone 39, illustrated in dotted lines in Fig. 3e, according to the Smart Cut™ method as described in the publication, « Silicon-On-Insulator Technology : Materials to VLSI, 2nd Edition » of Jean-Pierre Colinge by « Kluwer Academic Publishers », pages 50 and 51.

In zone 39 is located near the point defects of the layer 35, formed during amorphization.

This weakened zone 39 is formed in the layer 36, near the layer 35, and as it will be seen later on, allows the portion of the layer 36 to be detached.

This weakening implantation step preferably applies an implantation (with hydrogen exclusively, helium exclusively ...), a co-implantation with at least two different atomic species, for example hydrogen and helium, which are sequentially implanted, helium being preferably implanted before hydrogen.

It will be observed that in this example, parameters of said species implantation are selected so as to form a weakened zone 39 under the point defects 35 of intermediate structure 32'.

However, the weakening implantation parameters may be selected in such a way that the weakened zone 39 is located at the level of the point defects 35.

Next, with reference to Fig. 3f, a receiving substrate 40 is bonded onto the upper crystalline layer 34 of the intermediate structure 32' by any appropriate means.

In the following text, bonding means intimately contacting the receiving substrate 40 on the intermediate structure 32' in order to assemble them. This bonding may be obtained according to different methods:

- directly contacting a surface of the receiving substrate 40 in a semiconductor material, such as Si, with a surface of the intermediate structure 32',

- forming an amorphous material layer in order to make a connecting layer on a surface of the intermediate structure 32' and/or forming an amorphous material layer in order to make a second connecting layer on a surface of the receiving substrate 40 and contacting the surfaces of the respective connecting layers of the intermediate structure 32' and of the receiving substrate 40,

- forming a bonding interface on the surface of at least the intermediate structure 32' and/or the receiving substrate 40,

- combining both of the latter methods.

Accessary, when bonding the receiving substrate 40 on the face of the intermediate structure 32', the method according to the invention includes a plasma activation step in order to enhance the bonding and allow transfer at a lower temperature if necessary.

With reference to Fig. 3g, the crystalline layer 36 of the intermediate structure 32' is detached at the weakened zone 39 according to the Smart Cut™ method, by heat treatment and/or applying stresses.

One then proceeds with abrading the upper surface of the remaining crystalline layer of the intermediate structure 32', for example, by means of a chemical mechanical planarization (CMP) type method, until the amorphous layer 33 forms the upper layer of the intermediate structure 32' thereby eliminating the zone 35 rich in crystalline defects.

With reference to Fig. 3h, a first final substrate is obtained, comprising a lower receiving substrate 40, a central crystalline layer 34 and an upper doped amorphous layer 33.

Optionally, if the doping step has not yet been performed and if the goal is to obtain a final highly doped crystalline structure, dopants species 37' such as boron and/or phosphorus are implanted in the amorphous layer 33.

By means of recrystallization annealing, performed after the step for doping the amorphous layer 33, either straightaway after forming said amorphous layer 33 or after obtaining the first final substrate, with reference to Fig. 3i, the amorphous layer 33 will recrystallize from the crystalline layer 34 which plays a role of seed layer. During this recrystallization annealing, the dopant species initially implanted in the amorphous layer 33 will moreover be activated.

This annealing for recrystallizing and activating the dopant. species comprises low temperature heat treatment performed between 550°C and 650°C for one to two hours. It will be observed that the recrystallization annealing is performed without any formation of end-of-range (EOR) type point defects, the point defects having been eliminated during the previous CMP type abrasion step.

The thereby obtained substrate, as illustrated in Fig. 3i, comprises a lower receiving substrate 40 on the one hand, and an upper doped crystalline layer 41 on the other hand which does not have any EOR type point defect and which has a concentration of dopants larger than or equal to 1e20 at/cm$^3$.

Such a substrate is able to receive CMOS components such as transistors for example.

In this particular exemplary embodiment, the receiving substrate 40 is bonded onto the upper face of the intermediate structure 32'.

**Alternative embodiment with a surface amorphous layer and removal of point defects with weakening by implantation**

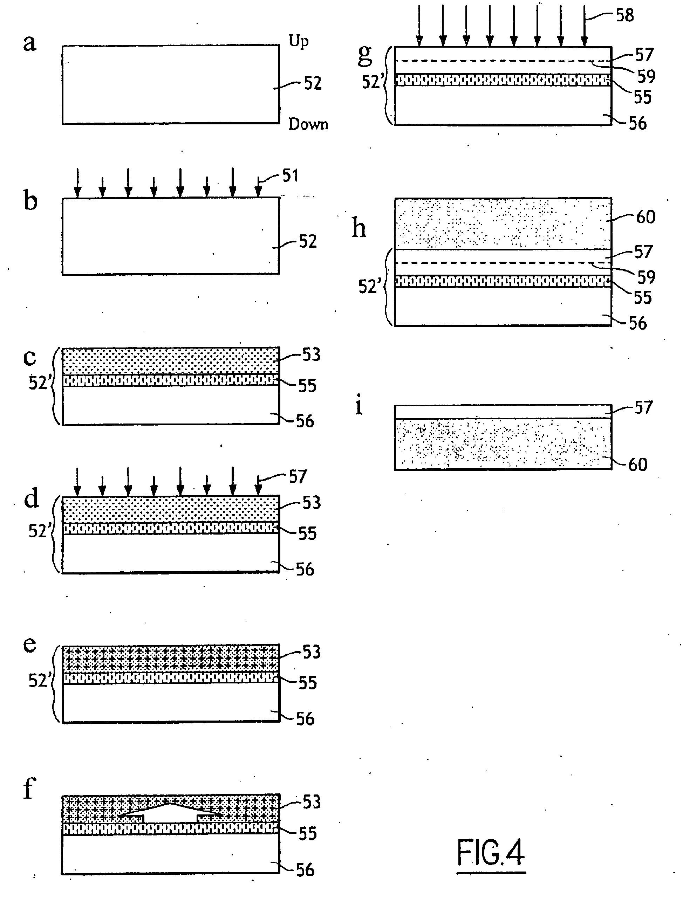

According to another embodiment of the invention, with reference to Fig. 4, the method includes a step for implanting species 51 (Fig. 4b) from the upper face of a substrate 20 (Fig. 4a) in order to form a surface amorphous layer 53, with reference to Fig. 4c.

The substrate 52 is in the same way as earlier, a semiconductor material such as silicon.

And species 51 may for example be Si.

In order to obtain a surface amorphous layer 53, the implantation parameters are controlled in order to retain in depth a region 56, the crystallinity of which is not changed by the implanted species 51.

It will be noted that the amorphous layer 53 may also be directly deposited on the substrate 52.

After forming the surface amorphous layer 53, the supporting substrate 52 has a so-called intermediate structure 52', with reference to Fig. 4c, comprising an upper surface amorphous layer 53, a central crystalline layer 55 containing point defects and a lower crystalline layer 56. These point defects are interstitial Si atoms; they correspond to the defects of layer 15 of Figs. 2c-2e.

With reference to Fig. 4d, dopant species 57 such as boron and/or phosphorus, are locally implanted or in the full plate in the surface amorphous layer 53 through the upper face of the atomic structure 52'.

The intermediate structure 52' then comprises an upper doped surface amorphous layer 53, a central crystalline layer 55 containing point defects, and a lower crystalline layer 56.

By recrystallization annealing, with reference to Fig. 4f, the doped surface amorphous layer 53 will recrystallize from the crystalline layer 56 which plays the role of seed layer. During the recrystallization annealing, the dopant species initially implanted in the surface amorphous layer 53, will moreover be activated.

This annealing for recrystallizing and activating the dopant species consists in a low temperature heat treatment performed between 550°C and 650°C for one to two hours.

The thereby obtained substrate, as illustrated in Fig. 4g, comprises an upper doped crystalline layer 57, a central crystalline layer 55 containing point defects and a lower crystalline layer 56.

Ions and/or gas species 58 are then implanted through the upper face of the substrate so as to form in the substrate, a buried weakened zone 59 in the doped crystalline layer 57, illustrated in dotted lines in Fig. 4g, according to the Smart Cut™ method as described in the publication, « Silicon-On-Insulator Technology : Materials to VLSI, 2nd Edition » of Jean-Pierre Colinge by « Kluwer Academic Publishers », pages 50 and 51.

The zone 59 is located near the point defects of the layer 55, formed during amorphization.

This weakened zone 59 is formed in the layer 57, near the layer 55, and, as it will be seen later on, allows the portion of the layer 56 to be detached.

This weakening implantation step preferably applies an implantation (with hydrogen exclusively, helium exclusively), a co-implantation of at least two different atomic species, for example hydrogen and helium which are sequentially implanted, helium being preferably implanted before hydrogen.

It will be observed that in this example, the parameters of said species implantation are selected so as to form a weakened zone 59 above the point defects 55 of the intermediate structure 52'.

With reference to Fig. 4h, a receiving substrate 60 is bonded onto the upper doped crystalline layer 57 of the intermediate structure 52' by any appropriate means.

With reference to Fig. 4i, the crystalline layer 56 and the layer 55 containing the point defects of the intermediate structure 52' are detached at the weakened zone 59 according to the Smart Cut™ method, by heat treatment and/or applying stresses.

One then proceeds with a treatment for finishing the upper face of the doped crystalline layer 57.

With reference to Fig. 4i, a final substrate consisting of a lower receiving substrate 60 and an upper doped crystalline layer 57 is obtained.

It will be noted that, in this alternative embodiment of the method according to the invention, which allows a substrate to be formed by direct silicon bonding (DSB) including a highly doped zone without any EOR, recrystallization of the amorphous layer 53 is performed before transfer onto the receiving substrate 60, unlike the previous alternative embodiment in which recrystallization of the amorphous layer is performed after the transfer where accurate control of the heat treatments was needed in order to avoid performing heat treatments at too high temperatures before SPE for activating the doping.

Thus, it will be observed that in this new alternative embodiment, a too high heat balance should not be applied, preferably a heat balance less than 400-500°C because the activated substrate remains in a metastable state.

Moreover, in this alternative embodiment, an insulating layer may also be provided for bonding.

**Alternative embodiment with a buried amorphous layer and removal of point defects with formation of a porous layer**

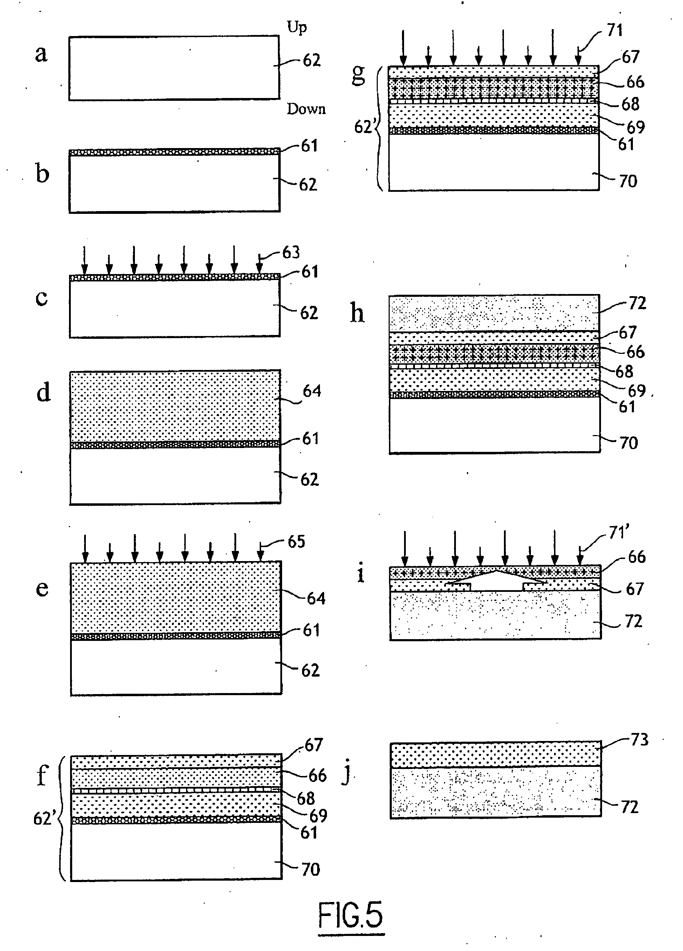

According to a third embodiment of the invention, with reference to Fig. 5, the method includes a step for forming a weakened porous layer 61 (Fig. 5b) on a substrate 62 (Fig. 5a) obtained in a semiconductor material such as silicon.

With reference to Figs. 5c and 5d, an upper crystalline layer 64 is deposited by epitaxy 63 on the weakened porous layer 62.

The method then includes a step for implanting species 65 (Fig. 5e) from the upper face of the crystalline layer 64 so as to form a buried amorphous layer 66, with reference to Fig. 5f.

Species 65 may for example be Si.

In order to obtain a buried layer 66, the implantation parameters are controlled so as to retain at the surface of the substrate, a region 67 which substantially do not receive any species 65.

After forming the buried amorphous layer 66, the substrate has a so-called intermediate structure 62', with reference to Fig. 5f, comprising a upper layer 67 which has remained crystalline, a buried amorphous layer 66 positioned underneath the upper crystalline layer 67, a central crystalline layer 68 containing point defects, a first lower crystalline layer 69, a weakened porous layer 61 and a second lower crystalline layer 70.

Optionally, with reference to Fig. 5g, the dopant species 71 such as boron and/or phosphorus, are locally implanted or in the full plate in the amorphous layer 66 through the upper face of the intermediate structure 62'. The amorphous layer 66 is thereby doped

With reference to Fig. 5h, a receiving substrate 72 is then bonded onto the upper crystalline layer 67 of the intermediate structure 62' by any appropriate means.

With reference to Fig. 5i, the crystalline layer 69 or the intermediate structure 62' is detached at the zone of the porous layer 61, by applying stresses.

One then proceeds with abrading the upper surface of the remaining crystalline layer 69 of the intermediate structure 62' for example by a chemical mechanical planarization (CMP) type method until the doped amorphous layer 66 forms the upper layer of the intermediate structure 62' (Fig. 5i).

Optionally, if the doping step has not yet been performed and if the goal is to obtain a final highly doped crystalline structure, dopant species 71' such as boron and/or phosphorus, are implanted in the amorphous layer 66, with reference to Fig. 5i, thereby eliminating the zone 68 rich in point defects.

By recrystallization annealing, with reference to Fig. 5i, the doped amorphous layer 66 will recrystallize from the crystalline layer 67 which plays the role of seed layer. During this recrystallization annealing, the dopant species initially implanted in the amorphous layer 66 will moreover be activated

This annealing for recrystallizing and activating dopant species consists in a low temperature heat treatment performed between 550°C and 650°C for one to two hours. It will be observed that this recrystallization annealing is performed without any formation of end-of-range type point defects, the crystalline point defects causing the EOR defects having been eliminated during the abrasion step performed previously.

The thereby obtained substrate, illustrated in Fig. 5j, comprising a lower receiving substrate 72 and an upper doped crystalline layer 73, is able to receive CMOS components such as transistors for example.

### Alternative embodiment with a surface amorphous layer and removal of point defects with formation of a porous layer

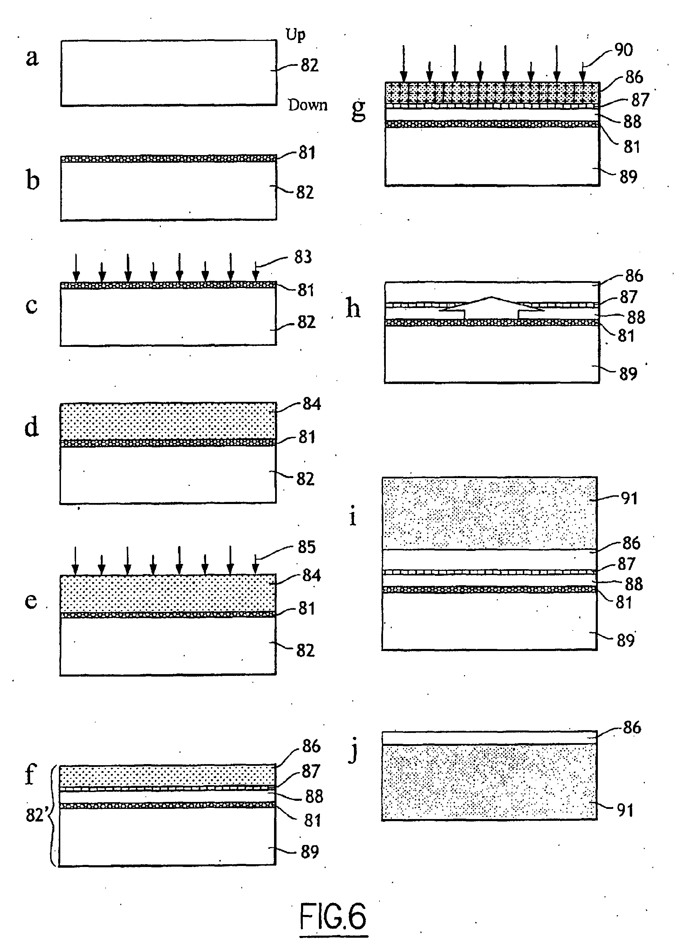

According to a fourth embodiment of the invention, with reference to Fig. 6, the method includes a step for forming a weakened porous layer 81 (Fig. 6b) on a substrate 82 (Fig. 6a) obtained in a semiconductor material such as silicon.

With reference to Figs. 6c and 6d, an upper crystalline layer 84 is deposited by epitaxy 83 on the weakened porous layer 81.

The method then includes a step for implanting species 85 (Fig. 6e) from the upper face of the crystalline layer 84 in order to form a surface amorphous layer 86, with reference to Fig. 6f.

Species 85 may for example be Si.

In order to obtain a surface amorphous layer 86, the implantation parameters are controlled in a way well-known to one skilled in the art.

It will be observed that the amorphous surface layer 86 may also be made by directly depositing an amorphous layer.

After forming the surface amorphous layer 86, the substrate has a so-called intermediate structure 82', with reference to Fig. 6f, comprising an upper surface amorphous layer 86, a central crystalline layer 87 containing point defects, a first crystalline layer 88, a so-called buried crystalline layer, a weakened porous layer 81 positioned underneath said buried crystalline layer 88 and a second crystalline layer 89, a so-called lower crystalline layer.

Optionally, with reference to Fig. 6g, dopant species 90 such as boron and/or phosphorus, are locally implanted or in the full plate in the surface amorphous layer 86 through the upper face of the intermediate structure 82'. The surface amorphous layer 86 is thereby doped.

By recrystallization annealing, with reference to Fig. 6h, the doped surface amorphous layer 86 will recrystallize from the crystalline layer 88 which plays the role of seed layer. During this recrystallization annealing, the dopant species initially implanted in the surface amorphous layer 86 will moreover be activated.

This annealing for recrystallizing and activating dopant species in the same way as previously, consists in a low temperature heat treatment performed between 550°C and 650°C for one to two hours.

The thereby obtained substrate, illustrated in Fig. 6h, comprises an upper doped crystalline layer, capable of receiving CMOS components such as transistors for example, a central crystalline layer 87 containing EOR type point defects, a first crystalline layer 88, a so-called buried crystalline layer, a weakened porous layer 81 positioned underneath said buried crystalline layer 88 and a second crystalline layer 89, a so-called lower crystalline layer.

With reference to Fig. 6i, a receiving substrate 91 is bonded onto the upper doped crystalline layer 86 of the intermediate structure 82' by any appropriate means

With reference to Fig. 6i, the lower crystalline layer 89 is detached at the weakened porous layer 81 by applying stresses.

One then proceeds with abrading the upper surface of the remaining crystalline layer 88 of the intermediate structure 82', for example by a chemical mechanical planarization (CMP) type method until the doped crystalline layer 86 forms the upper layer of the intermediate structure 82' (Fig. 6j) thereby eliminating the EOR defects present within the layer 87.

The thereby obtained substrate, illustrated in Fig. 6j, comprising a lower receiving substrate 91 and an upper doped crystalline layer 86, is capable of receiving CMOS components such as transistors for example.

Optionally, one proceeds with a treatment for finishing the upper face of the doped crystalline layer 86.

A particular but non-limiting exemplary embodiment of a substrate obtained according to the invention will be described hereafter with reference to Fig. 3.

Example:

With reference to Fig. 3, the method for making a structure includes a step for implanting species 101, silicon, (Fig.3b) from the upper face of a substrate 102 (Fig. 3a) obtained in a semiconductor material such as silicon, in order to form a buried amorphous layer 103, with reference to Fig. 3c.

In order to obtain a buried amorphous layer 103, the implantation parameters are controlled in order to retain at the surface of the substrate 102, a region 104.

The characteristics of the buried amorphous layer (depth and width) are totally adjustable according to the dose and implantation energy. After having selected the iso-electric species of the silicon to be implanted in the Si substrate to amorphize it: Ge, Sn or Si itself, the energy and dose should be selected. Here is the protocol with which these characteristics may be established.

The most used model is that of the critical energy density as initially proposed by Stein and Vook « E.P. EerNisse; Investigation of Ion Implantation Damage with Stress », Proc.1st INT. Conf. On Ion Implantation, Gordon and Breach, London, 17 (1971). When a critical concentration of point defects is reached, the crystal spontaneously transits to the amorphous state. The defect concentration is related to the nuclear energy density received by the target. With the critical concentration of the defects is associated a critical value of the deposited damage energy density in nuclear collisions ($E_dc$). As a result, if the latter is reached, the crystal/amorphous transition occurs. From this model, it is possible to infer the depth x at which is located the crystal/amorphous interface by means of the following relationship:

$$\text{Dose} * Ed(x) = E_dc.$$

The critical energy density $E_dc$ is a widely investigated experimental parameter for amorphization of Si by implanting $Si^+$, $Ge^+$ or $Sn^+$ ions. For example, in the case of germanium, this value is 2 eV/at. From stimulations by means of commercial computers such as FLOOPS or LUPIN (registered trade marks), it is possible to obtain the damage energy distribution per incident ion at depth, x (Ed(x)). For a given implantation energy, it is then possible to localize in depth the amorphous zone by plotting the curve [Dose*Ed(x)] versus the depth x.

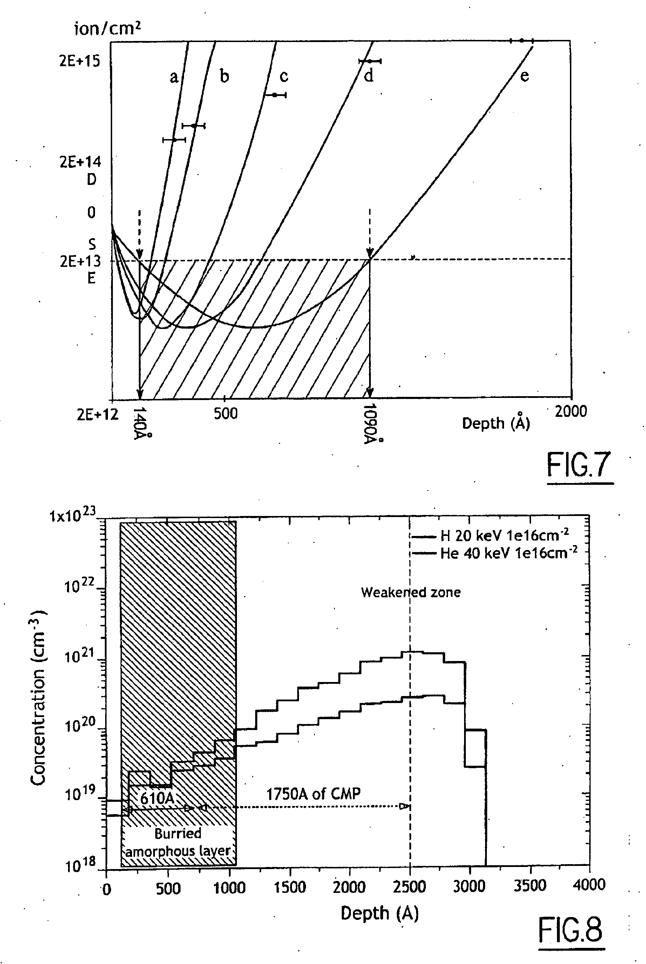

The graph of Fig. 7 gives an example of curves for the case of a Ge implantation at 15 keV (a) 25 keV (b) 50 keV (c), 80 keV (d), 150 keV (e) in a Si substrate. The critical damage energy is taken to be the standard value of 2 eV/at. By means of these curves, it is then possible to provide the characteristics of the amorphous layers. At a given energy, for example 15 keV, according to the dose of implanted Ge, the amorphous layer will be buried or will open onto the surface. In order that it should be buried as in said invention, the implantation dose needs to remain lower than the first value at abscissa x=0 of the curve corresponding to the selected implantation energy. For example, in the case of implantation of Ge+ at 150 keV (curve e) in Si, the implantation dose needs to be less than 5e13 at/Cm$^{-2}$ so that the layer is buried. Thus, with a dose of 3e13 at/Cm$^{-2}$, an amorphous layer is obtained which starts at about 140 A under the surface and ends at a depth of 1090 A, i.e., an amorphous layer thickness of about 950 Å. (wherein 10Å= 1nm). The crystalline structure is therefore retained over the first 140 Angstroms. This crystal film will serve as a seed for subsequent rebuilding of the amorphous layer.

After forming the buried amorphous layer 103, the supporting substrate 102 has a so-called intermediate structure 102', with reference to Fig. 3c, comprising an upper layer 104 which has remained crystalline, a buried amorphous layer 103 positioned under the upper crystalline layer 104, a central crystalline layer 105 containing point defects and a lower crystalline layer 106. These point defects are interstitial Si atoms; they correspond to defects of the layer 15 of Figs. 2c-2e.

With reference to Fig. 3d, dopant species 107 such as boron and/or phosphorus are locally implanted or in the full plate in the amorphous layer 103 through the upper face of the intermediate structure 102'.

Ions and/or gas species 108 are then implanted through the upper face of the substrate in order to form in the substrate, a buried weakened zone 109, illustrated in dotted lines in Fig. 3e, according to the Smart Cut™ method as described in the publication, « Silicon-On-Insulator Technology : Materials to VLSI, 2nd Edition » of Jean-Pierre Colinge by « Kluwer Academic Publishers », pages 50 and 51.

The zone 109 is located near the point defects of the layer 105 formed during amorphization.

This weakened zone 109 is formed in the layer 106, near the layer 105 and as it will be seen later on, allows the portion of the layer 106 to be detached.

This weakening implantation step preferably applies an implantation (with hydrogen exclusively, helium exclusively), a co-implantation of at least two different atomic species, for example hydrogen and helium which are sequentially implanted, helium being preferably implanted before hydrogen.

Implantation of hydrogen and helium is adjusted in order to position the concentration maxima beyond 1090 A in the above example. Hydrogen may be implanted for example at 25 keV with a dose of 1e16 cm$^{-2}$ which positions the concentration maximum at about a depth of 2500 A, i.e., 1410 A beyond the second amorphous/crystal interface as this may be seen in Fig. 8. Helium will be implanted at about 40 keV and 1e16 cm$^{-2}$ which positions the concentration maximum at a depth of about 2750 A, i.e., 250 Å beyond the concentration maximum of the first hydrogen implantation. Fracture of the material will occur in the « fracture zone» illustrated in dotted lines on the graph of Fig. 8 approximately at the concentration maximum of hydrogen, i.e. at about 2500 A under the surface.

With reference to Fig. 3f, a receiving substrate 110 is then bonded onto the upper crystalline layer 104 of the intermediate structure 102' by any appropriate means.

With reference to Fig. 3g, the crystalline layer 106 of the intermediate structure 102' is detached at the weakened zone 109 according to the Smart Cut™ method, by heat treatment and/or applying stresses.

One then proceeds with abrading the upper surface of the remaining crystalline layer of the intermediate structure 102' for example by means of a chemical mechanical planarization (CMP) type method until the amorphous layer 103 forms the upper layer of the intermediate structure 102' thereby eliminating the zone 105 rich in point defects.

The abrasion step consists in a well-known mechano-chemical polishing called CMP, of the present state of the art, in order to remove 1750 A of silicon according to the graph of Fig. 8.

With reference to Fig. 3h, a first final substrate is obtained comprising a lower receiving substrate 110, a central crystalline layer 104 with a thickness of 140 Å and an upper doped amorphous layer 103 with a thickness of 610 Å.

By recrystallization annealing, performed after the step for doping the amorphous layer 103, either immediately after the formation of the amorphous layer 103 or after obtaining the first final substrate, with reference to Fig. 3i, the amorphous layer 103 will recrystallize from the crystalline layer 104 which plays the role of seed layer. During this recrystallization annealing, the dopant species initially implanted in the amorphous layer 103 will moreover be activated.

This annealing for recrystallizing and activating dopant species consists in a low temperature heat treatment performed between 550°C and 650°C for one to two hours.

The thereby obtained substrate, as illustrated in Fig. 3i, comprises a lower receiving substrate 110 and an upper doped crystalline layer 111 with a thickness of 140 A.

The detailed examples above illustrate embodiments in which removal of the layer of the intermediate structure in which point defects have formed, is performed by detachment at a weakened zone which has been formed in the intermediate structure.

However, these examples are not limiting and it is also possible to perform such a removal by etching after bonding, the rear face of the intermediate structure in order to remove a controlled thickness thereof, for example by etching or polishing, of even by any other known form of mechanical and/or chemical etching.

Finally, it is very obvious that all the layer transfer parameters may be contemplated notably depending on the nature of the implanted species, of the implantation energy and of the implantation dose, and the examples which have just been described are by no means limiting, as to the fields of application of the invention.

## Claims

1. A method for making a structure comprising at least one thin layer on a receiving substrate (40,60,72,91), wherein it includes at least the steps of:

   - forming from sad a supporting substrate a so-called intermediate substrate (32',52',62',82') comprising:

     o an amorphous layer (33,53,66,86),
     o a first crystalline layer (35,55,68,87) containing point defects and located immediately underneath said amorphous layer (33,53,66,86),
     o a second crystalline layer (36,56,70,89) located in the lower portion of the intermediate structure (32',52',62',82'),

   - implanting dopants in the amorphous layer (33,53,66,86),
   - carrying out a recrystallization annealing that recrystallizes the amorphous layer (33,53,66,86) and activates the dopants implanted in the amorphous layer,
   - bonding a receiving substrate (40,60,72,91) on the upper face of said intermediate structure (32',52',62',82'),
   - removing the second crystalline layer (36,56,70,89) and the first crystalline layer (35,55,68,87) of the intermediate structure (32', 52',62',82') containing said point defects.

2. The method according to claim 1, wherein the amorphous layer (33,53,66,86) is formed at the surface of the intermediate structure (32',52',62',82').

3. The method according to claim 2, wherein the amorphous layer (33,53,66,86) is made in the intermediate structure (32',52',62',82') so that it forms the upper layer, a so-called surface amorphous layer (53,86) of the intermediate structure (32',52',62', 82').

4. The method according to claim 1, wherein the amorphous layer (33,53,66,86) is made in the intermediate structure (32',52',62',82') so that it forms a buried layer, a so-called buried amorphous layer (33,53,66,86) located immediately below a third crystalline layer (34,67) located in the upper portion of the intermediate structure (32',52',62',82').

5. The method according to any of claims 3 or 4, wherein the amorphous layer (33,53,66,86) is obtained by implanting species in said supporting substrate (32,52,62,82).

6. The method according to any of claims 1 to 2, wherein before the step for bonding the receiving substrate (40,60,72,91), it includes the step for doping the amorphous layer (33,53,66,86) by implanting species through the upper face of said intermediate structure (32',52',62',82').

7. The method according to any of claims 1 to 2, wherein after the steps for forming the amorphous layer (33,53,66,86) and for removing the layer (35,55,68,87) of the intermediate structure (32',52', 62',82') containing said point defects and before the step for bonding a receiving substrate (40,60,72,91), it includes the step for doping the amorphous layer (33,53,66,86) by implanting species.

8. The method according to claim 1, wherein said heat treatment is performed between 550°C and 650°C for one to two hours.

9. The method according to any of the preceding claims, wherein the step for removing the layer (35,55,68,87) of the intermediate structure (32',52', 62',82') containing said point defects is obtained by creating a weakened zone (39,57,61,81) in the intermediate structure (32',52',62',82') and then by applying stresses.

**Patentansprüche**

1. Verfahren zum Herstellen einer Struktur, die wenigstens eine dünne Schicht auf einem empfangenden Substrat (40, 60, 72, 91) umfasst, wobei es wenigstens die folgenden Schritte umfasst:

- Bilden, aus einem Trägersubstrat, eines sogenannten Zwischensubstrats (32', 52', 62', 82'), das Folgendes umfasst:

o eine amorphe Schicht (33, 53, 66, 86),
o eine erste kristalline Schicht (35, 55, 68, 87), die Punktdefekte enthält und die sich unmittelbar unter der amorphen Schicht (33, 53, 66, 86) befindet,
o eine zweite kristalline Schicht (36, 56, 70, 89), die sich im unteren Teil der Zwischenstruktur (32', 52', 62', 82') befindet,

- Implantieren von Dotierstoffen in der amorphen Schicht (33, 53, 66, 86),
- Ausführen eines Rekristallisationstemperns, das die amorphe Schicht (33, 53, 66, 86) rekristallisiert und das die in der amorphen Schicht implantierten Dotierstoffe aktiviert,
- Bonden eines empfangenden Substrats (40, 60, 72, 91) auf der oberen Fläche der Zwischenstruktur (32', 52', 62', 82'),
- Entfernen der zweiten kristallinen Schicht (36, 56, 70, 89) und der ersten kristallinen Schicht (35, 55, 68, 87) der Zwischenstruktur (32', 52', 62', 82'), die die Punktdefekte enthält.

2. Verfahren nach Anspruch 1, wobei die amorphe Schicht (33, 53, 66, 86) an der Oberfläche der Zwischenstruktur (32', 52', 62', 82') ausgebildet wird.

3. Verfahren nach Anspruch 2, wobei die amorphe Schicht (33, 53, 66, 86) in der Zwischenstruktur (32', 52', 62', 82') ausgeführt wird, derart, dass sie die obere Schicht bildet, eine sogenannte amorphe Oberflächenschicht (53, 86) der Zwischenstruktur (32', 52', 62', 82').

4. Verfahren nach Anspruch 1, wobei die amorphe Schicht (33, 53, 66, 86) in der Zwischenstruktur (32', 52', 62', 82') ausgeführt wird, derart, dass sie eine vergrabene Schicht bildet, eine sogenannte vergrabene amorphe Schicht (33, 53, 66, 86), die sich unmittelbar unterhalb einer dritten kristallinen Schicht (34, 67) befindet, die sich im oberen Teil der Zwischenstruktur (32', 52', 62', 82') befindet.

5. Verfahren nach einem der Ansprüche 3 oder 4, wobei die amorphe Schicht (33, 53, 66, 86) durch das Implantieren von Atomsorten im Trägersubstrat (32, 52, 62, 82) erhalten wird.

6. Verfahren nach einem der Ansprüche 1 bis 2, wobei vor dem Schritt zum Bonden des empfangenden Substrats (40, 60, 72, 91) es den Schritt zum Dotieren der amorphen Schicht (33, 53, 66, 86) durch das Implantieren von Atomsorten durch die obere Fläche der Zwischenstruktur (32', 52', 62', 82') umfasst.

7. Verfahren nach einem der Ansprüche 1 bis 2, wobei nach den Schritten zum Ausbilden der amorphen Schicht (33, 53, 66, 86) und zum Entfernen der Schicht (35, 55, 68, 87) der Zwischenstruktur (32', 52', 62', 82'), die die Punktdefekte enthält, und vor dem Schritt zum Bonden eines empfangenden Substrats (40, 60, 72, 91) es den Schritt zum Dotieren der amorphen Schicht (33, 53, 66, 86) durch das Implantieren von Atomsorten umfasst.

8. Verfahren nach Anspruch 1, wobei die Wärmebehandlung zwischen 550°C und 650°C und für ein bis zwei Stunden ausgeführt wird.

9. Verfahren nach einem der vorhergehenden Ansprüche, wobei der Schritt zum Entfernen der Schicht (35, 55, 68, 87) der Zwischenstruktur (32', 52', 62', 82'), die die Punktdefekte enthält, durch das Erzeugen einer Schwächungszone (39, 57, 61, 81) in der Zwischenstruktur (32', 52', 62', 82') und das anschließenden Anwenden von Spannungskräften erreicht wird.

## Revendications

**1.** Procédé de fabrication d'une structure comprenant au moins une couche mince sur un substrat récepteur (40, 60, 72, 91), qui comprend au moins les étapes suivantes :

- formation à partir d'un substrat support d'un substrat dit intermédiaire (32', 52', 62', 82') comprenant :

  o une couche amorphe (33, 53, 66, 86),
  o une première couche cristalline (35, 55, 68, 87) contenant des défauts ponctuels et située immédiatement sous ladite couche amorphe (33, 53, 66, 86),
  o une deuxième couche cristalline (36, 56, 70, 89) située dans la partie inférieure de la structure intermédiaire (32', 52', 62', 82'),

- implantation de dopants dans la couche amorphe (33, 53, 66, 86),
- mise en oeuvre d'un recuit de recristallisation qui recristallise la couche amorphe (33, 53, 66, 86) et active les dopants implantés dans la couche amorphe,
- collage d'un substrat récepteur (40, 60, 72, 91) sur la face supérieure de ladite structure intermédiaire (32', 52', 62', 82'),
- élimination de la deuxième couche cristalline (36, 56, 70, 89) et de la première couche cristalline (35, 55, 68, 87) de la structure intermédiaire (32', 52', 62', 82') contenant lesdits défauts ponctuels.

**2.** Procédé selon la revendication 1, dans lequel la couche amorphe (33, 53, 66, 86) est formée à la surface de la structure intermédiaire (32', 52', 62', 82').

**3.** Procédé selon la revendication 2, dans lequel la couche amorphe (33, 53, 66, 86) est formée dans la structure intermédiaire (32', 52', 62', 82') de façon à constituer la couche supérieure, dite couche amorphe superficielle (53, 86) de la structure intermédiaire (32', 52', 62', 82').

**4.** Procédé selon la revendication 1, dans lequel la couche amorphe (33, 53, 66, 86) est formée dans la structure intermédiaire (32', 52', 62', 82') de façon à constituer une couche enterrée, dite couche amorphe enterrée (33, 53, 66, 86) située immédiatement sous une troisième couche cristalline (34, 67) qui se trouve dans la partie supérieure de la structure intermédiaire (32', 52', 62', 82').

**5.** Procédé selon l'une quelconque des revendications 3 ou 4, dans lequel la couche amorphe (33, 53, 66, 86) est obtenue par implantation d'espèces dans ledit substrat support (32, 52, 62, 82).

**6.** Procédé selon l'une quelconque des revendications 1 à 2 qui comprend, avant l'étape de liaison du substrat récepteur (40, 60, 72, 91), l'étape de dopage de la couche amorphe (33, 53, 66, 86) par implantation d'espèces à travers la face supérieure de ladite structure intermédiaire (32', 52', 62', 82').

**7.** Procédé selon l'une quelconque des revendications 1 à 2 qui comprend, après les étapes de formation de la couche amorphe (33, 53, 66, 86) et d'élimination de la couche (35, 55, 68, 87) de la structure intermédiaire (32', 52', 62', 82') contenant lesdits défauts ponctuels et avant l'étape de collage d'un substrat récepteur (40, 60, 72, 91), l'étape de dopage de la couche amorphe (33, 53, 66, 86) par implantation d'espèces.

**8.** Procédé selon la revendication 1, dans lequel ledit traitement thermique est mis en oeuvre entre 550 et 650 °C pendant une à deux heures.

**9.** Procédé selon l'une quelconque des revendications précédentes, dans lequel l'étape d'élimination de la couche (35, 55, 68, 87) de la structure intermédiaire (32', 52', 62', 82') contenant lesdits défauts ponctuels est mise en oeuvre par création d'une zone affaiblie (39, 57, 61, 81) dans la structure intermédiaire (32', 52', 62', 82') et ensuite par application de contraintes.

Up

a

Down

1

2

1   b

3
4   c

**FIG.1**

PRIOR ART

10

11
10

12
15
13

c

10

14
12
15
13

d

10

12
15
13

e

10

12
15
13

f

10

15

g

10

**FIG.2**

PRIOR ART

a

Up

32

Down

b

31

32

c

34

33

32'

35

32

36

d

37

34

33

35

36

32'

e

38

34

33

35

39

36

32'

f

40

34

33

35

39

36

32'

g

36

39

35

33

34

32'

40

h

37'

33

34

40

i

41

40

## FIG.3

a

Up

52

Down

b

51

52

c

52'

53
55
56

d

57

53
55
56

52'

e

53
55

52'

56

f

53

55

56

g

58

57
59
55

52'

56

h

60
57
59
55

52'

56

i

57

60

FIG.4

## FIG.5

a

Up

82

Down

b

81

82

c

83

81

82

d

84

81

82

e

85

84

81

82

f

86

87

88

82'

81

89

g

90

86

87

88

81

89

h

86

87

88

81

89

i

91

86

87

88

81

89

j

86

91

FIG.6

FIG.7

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6638872 B

**Non-patent literature cited in the description**

- **JEAN-PIERRE COLINGE.** Silicon-On-Insulator Technology : Materials to VLSI. Kluwer Academic, 50, 51

- E.P. EerNisse; Investigation of Ion Implantation Damage with Stress. **STEIN ; VOOK.** Proc.1st INT. Conf. On Ion Implantation. Gordon and Breach, 1971, 17